# EUROPEAN PATENT SPECIFICATION

(11) **EP 3 962 243 B1**
(45) Date of publication and mention of the grant of the patent: **30.10.2024**
(21) Application number: 20193829.7
(22) Date of filing: 01.09.2020
(51) Int. Cl.: H05K 1/02, H05K 3/30, H05K 3/46, H05K 3/00, H05K 3/40

(54) **CIRCUIT BOARD, CONTROL UNIT, ELECTRONIC DEVICE, AND METHOD OF ASSEMBLING AN ELECTRONIC DEVICE**
LEITERPLATTE, STEUEREINHEIT, ELEKTRONISCHE VORRICHTUNG UND VERFAHREN ZUR MONTAGE EINER ELEKTRONISCHEN VORRICHTUNG
CARTE DE CIRCUIT IMPRIMÉ, UNITÉ DE COMMANDE, DISPOSITIF ÉLECTRONIQUE ET PROCÉDÉ D'ASSEMBLAGE D'UN DISPOSITIF ÉLECTRONIQUE

(43) Date of publication of application: 02.03.2022
(73) Proprietor: Rohde & Schwarz GmbH & Co. KG, 81671 München (DE)
(72) Inventor: Haas, Achim, 81671 München (DE); Escherich, Andreas, 81671 München (DE)
(74) Representative: Novagraaf Group

(56) References cited:
- CN-U- 209 676 572
- US-A1- 2010 246 155
- US-A1- 2014 102 763

## Description

The invention relates to a circuit board for a handheld radio. The invention further relates to a control unit, an electronic device, and a method for assembling an electronic device.

Electronic circuit boards are one of the most important building blocks for many electronic devices, and are known in a large variety. Usually, electronic circuitry of such circuit boards is provided on a rigid carrier member that is used for mounting the circuit board to a housing of the electronic device. Moreover, flexible circuit boards are known, wherein the electronic circuitry is provided on a flexible carrier member.

The rigid carrier member is usually mounted to the housing of the electronic device via conventional mounting techniques, for example via screws, bolts, etc.

In order to ground the electronic circuit board, additional components such as conducting springs may have to be provided, which are used to electrically connect the circuit board with a housing or a ground plane of the electronic device.

Accordingly, the mounting of the electronic circuit board may be rather time-consuming, as multiple components have to be assembled or rather connected to each other.

US 2014 0 102 763 A1 discloses a circuit board according to the preamble of claim 1.

CN 209 676 572 U discloses a rigid-flexible circuit board comprising a flexible circuit board and a rigid circuit board. The rigid circuit board is attached to the flexible circuit board by means of an adhesive layer.

Thus, the object of the present invention is to provide a circuit board as well as a method for assembling an electronic device that allow for a simpler mounting of the circuit board in the electronic device.

According to the invention, the problem is solved by a circuit board for a handheld radio according to claim 1.

The circuit board according to the invention is mountable directly to a housing of an electronic device (particularly to a handheld radio) by means of the elastic mounting member in a particularly simple fashion. For example, the circuit board may be glued to the housing via the elastic mounting member.

As the mounting member is elastic, manufacturing tolerances of the electronic circuit board and/or of the housing of the electronic device are compensated at least partially by the elastic mounting member.

Moreover, the flexible connecting portion ensures that the circuit board can be connected to the other electronic components (e.g. of the handheld radio) in an easy manner, as the flexible connecting portion can simply be bent such that it contacts the corresponding electronic component.

Additionally, the flexible connecting portion also compensates for manufacturing tolerances of the circuit board, and/or for manufacturing tolerances of the handheld radio to which the circuit board is to be mounted.

Particularly, the connecting portion provides an electrical low-resistance contact to the at least one other electronic component (e.g. of the handheld radio).

According to an aspect of the invention, the elastic mounting member comprises an adhesive film. Particularly, the adhesive film is arranged on a bottom side of the elastic mounting member, wherein the bottom side faces away from the circuit board. Thus, the circuit board may be glued into the electronic device, particularly to the housing of the electronic device by means of the adhesive film. Thus, the mounting portion can be mounted to the housing in a particularly simple fashion.

Additionally, an adhesive film may be provided between the top side of the elastic mounting member and the bottom side of the circuit board. In other words, the elastic mounting member may be glued to the circuit board.

According to another aspect of the invention, the adhesive film is covered with a removable cover strip. More precisely, the removable cover strip may be arranged on the bottom side of the elastic mounting member, which faces away from the mounting portion. This way, handling of the circuit board during the manufacturing process is facilitated, as an unwanted gluing of the circuit board to other objects is prevented by the cover strip. Moreover, the cover strip effectively prevents dust or other small objects from sticking to the adhesive film before mounting of the circuit board.

In order to mount the circuit board, the cover strip is simply removed from the adhesive film, and the circuit board is glued to the housing of the electronic component by means of the adhesive film.

Particularly, the removable cover strip comprises several cover strip portions, wherein the several cover strip portions are removable individually. In other words, the removable cover strip is divided into at least two different cover strip portions, wherein each portion can be removed from the adhesive film individually.

For example, neighboring cover strip portions may be separated from each other by means of a perforation in the cover strip that facilitate individual removal of the cover strip portions.

In a further embodiment of the invention, the elastic mounting member comprises a rubber foam pad. As rubber foam is rather inexpensive, the circuit board can be manufactured in a particularly cost effective manner.

Particularly, at least a bottom side of the rubber foam pad may be covered with the adhesive film described above, wherein the bottom side of the rubber foam pad faces away from the mounting portion. Thus, the bottom side of the rubber foam pad faces away from the circuit board. For instance, the rubber foam pad is integrally connected via its top side to the circuit board, particularly the mounting portion. Put differently, the rubber foam is molded to the circuit board, for instance injection-molded.

Additionally, a top side of the rubber foam pad may be covered with an adhesive film. Accordingly, the rubber foam pad may be glued to the bottom side of the circuit board. Hence, the rubber foam pad may be manufactured separately and connected with the circuit board.

Of course, the elastic mounting member may be fabricated from any other suitable elastic material other than rubber foam.

According to another aspect of the invention, the at least one grounding portion is established as a lug being immediately connected to the circuit board. The at least one lug protrudes from the mounting portion either horizontally or at an angle with respect to a plane defined by the mounting portion.

In general, the at least one lug is electrically conductive, and is electrically connected to a ground plane of the electronic circuit. Thus, if the lug contacts a housing of an electronic device, the ground plane of the circuit board is electrically connected to the housing, thereby enhancing electromagnetic screening of the circuit board.

Particularly, the mounting portion may comprise several grounding portions, wherein each of the grounding portions may be established as a lug. Each of the grounding portions may be brought into electrical contact with the housing of the electronic device. This way, the electromagnetic screening of the circuit board is enhanced even further.

In a further embodiment of the invention, the at least one grounding portion is bendable with respect to the mounting portion. Thus, the grounding portion can be bent into a suitable positon for contacting the housing of the electronic device in a particularly simple fashion. In other words, the grounding contacts of the circuit board, i.e. the at least one grounding portion, can be adapted to the particular form of the housing to which the circuit board is mounted. Moreover, manufacturing tolerances of the circuit board and/or of the housing of the electronic device can be compensated by bending the at least one grounding portion to the needed position.

The at least one grounding portion may comprise a conductive metal, particularly gold. Particularly, the grounding portion may be covered with the conductive metal, for example with gold. Due to its low reactivity and its relative softness compared to other metals, gold is particularly suitable as a cover material for electrical contacts.

Particularly, the mounting portion has an essentially rectangular shape. Therein and in the following, the term "essentially rectangular" is understood to denote a shape that may have small deviations from an actual rectangle. For example, such deviations include one or more of the following: rounded corners, protrusions, and/or recesses.

However, it is to be understood that the mounting portion may have any other suitable shape.

According to an aspect of the invention, the mounting portion comprises at least one lateral recess or lug. The lateral recess or lug allows for a secure positioning during the mounting of the circuit board. For example, the housing of the electronic device to which the circuit board is mounted may comprise a lug or recess that corresponds to the lateral recess or lug of the circuit board, respectively. In order to securely position the circuit board, the lug of the housing is simply inserted into the recess of the circuit board, or the lug of the circuit board is inserted into the recess of the housing.

Particularly, the mounting portion may comprise two lateral recesses or two lateral lugs that are positioned at opposite lateral sides of the mounting portion. The two recesses or lugs of the mounting portion cooperate with two corresponding lugs or recesses of the housing of the electronic device. This way, the circuit board can be positioned in a particularly stable manner.

The flexible connecting portion may comprise a printed circuit board. Accordingly, a flexible electric connection is provided by means of the printed circuit board, such that manufacturing tolerances of the electronic device and/or manufacturing tolerances of the circuit board can be compensated by means of the flexible connecting portion in three dimensions.

According to another aspect of the invention, the connecting portion comprises a plug connector, particularly wherein the plug connector is arranged at an end of the connecting portion being opposite to the mounting portion. Accordingly, the full length of the connecting portion is available for compensating tolerances and for bridging the distance between the designated mounting position of the electronic circuit board and the electronic component to which the circuit board is to be connected.

According to the invention, the problem further is solved by a control unit, particularly for a handheld radio, comprising a circuit board described above, wherein the control unit is established as a switch.

The control unit may comprise at least one snap dome that is located on the circuit board, particularly at a side of the circuit board facing away from the elastic mounting member. The at least one snap dome may be used for switching operation.

Generally, the electronic circuit is configured to control at least one functionality of the electronic device.

Particularly, the electronic circuit is configured to switch between at least two different operational modes of the electronic device, such as "on" and "off", or between different channels of the handheld radio.

Alternatively or additionally, the electronic circuit may be configured to control illumination means of the electronic device, such as LEDs. For example, the electronic circuit may control the illumination means to show a certain light signal.

Alternatively or additionally, the electronic circuit may be configured to control a display of the electronic device.

Regarding the advantages and further properties of the control unit, reference is made to the explanations given above with respect to the circuit board, which also hold for the control unit and vice versa.

According to the invention, the problem further is solved by an electronic device, particularly a handheld radio, comprising a housing, a circuit board described above, and/or a control unit described above, wherein the grounding portion of the circuit board immediately abuts the housing.

Regarding the advantages and further properties of the electronic device, reference is made to the explanations given above with respect to the circuit board, which also hold for the electronic device and vice versa.

According to the invention, the problem further is solved by a method of assembling an electronic device, wherein the method comprises the steps of:
- providing a circuit board described above,
- bending the at least one grounding portion with respect to the mounting portion, and
- inserting the circuit board into a housing of the electronic device such that the at least one bent grounding portion immediately abuts the housing.

Particularly, the circuit board or rather the mounting portion of the circuit board is glued into the housing by means of the elastic mounting member, or more precisely by means of the adhesive layer on the rubber foam pad described above.

Manufacturing tolerances of the electronic device and of the circuit board are compensated by the grounding portions in a simple manner, as the grounding portions can be bent in the needed manner such that they contact the housing irrespective of certain manufacturing tolerances.

Regarding the further advantages and further properties of the method, reference is made to the explanations given above with respect to the circuit board, which also hold for the method and vice versa.

Generally, the at least one grounding portion is bent such that it encompasses the elastic mounting member, thereby providing a sandwiched structure of the circuit board. In the sandwiched structure, the rigid mounting portion is associated with an upper layer, the elastic mounting member is associated with a medium layer, and the at least one grounding portion is associated with a lower layer, wherein the at least one grounding portion extends from the rigid mounting portion in the unfolded or rather non-bent state.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows an electronic device according to the invention;
- Figure 2 schematically shows a top view of a circuit board of the electronic device of Figure 1;
- Figure 3 schematically shows a bottom view of the circuit board of Figure 2;
- Figure 4 shows a bottom view of an elastic mounting member of the circuit board of Figure 2;
- Figure 5 shows a top view of the elastic mounting member of Figure 4, and
- Figure 6 shows a flow chart of a method for assembling the electronic device of Figure 1.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

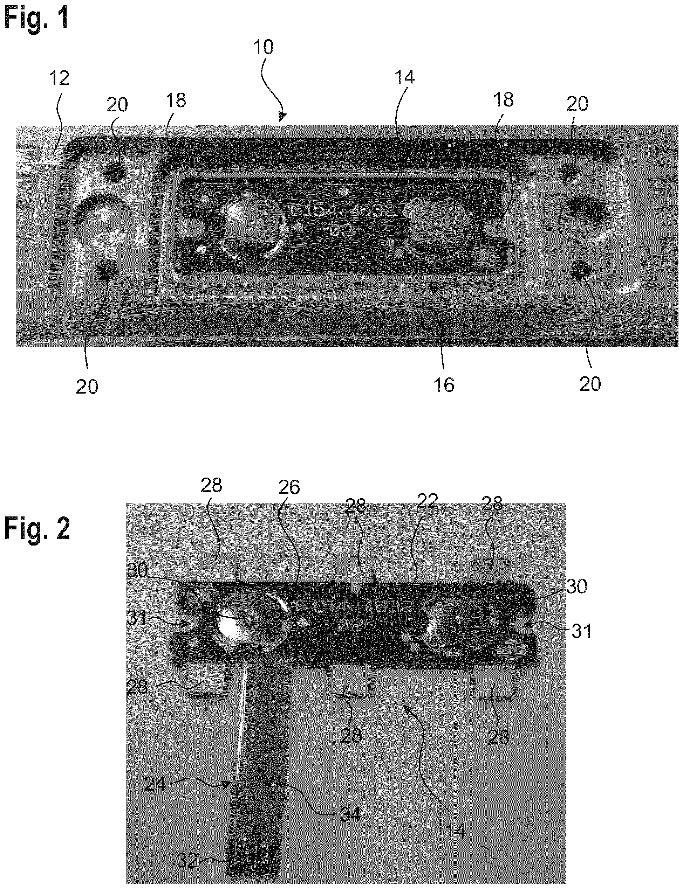

Figure 1 shows a portion of an electronic device 10 comprising a metal housing 12 and a circuit board 14 that is mounted to the housing 12.

The electronic device 10 may be established as a handheld radio.

The circuit board 14 may be established as a switch for the electronic device 10, particularly as a switch for the handheld radio. This embodiment is, without restriction of generality, described below.

However, it is to be understood that the circuit board 14 may be configured to control any functionality of the electronic device 10. For example, the circuit board 14 may be configured to control illumination means of the electronic device 10, such as LEDs. For example, the circuit board 14 may control the illumination means to show a certain light signal. As a further example, the circuit board 14 may be configured to control a display of the electronic device 10.

The housing 12 comprises a depression 16 for mounting the circuit board 14. The depression 16 may have a stepped shape, such that an outer area of the depression 16 has a first depth being smaller than a second depth of an inner area of the depression 16.

The circuit board 14 is mounted to the housing 12 in the inner area of the depression 16.

The housing 12 comprises two lugs 18 that are provided at opposite sides of the depression 16. The functionality of the lugs 18 will be described in more detail below.

The housing 12 further comprises threaded holes 20, wherein a cover portion of the housing 12 may be screwed onto the housing 12 via the threaded holes 20. Particularly, a thickness of the cover portion may be equal to the depth of the outer area of the depression 16, such that the housing 12 has a level surface after the cover portion is mounted.

Figure 2 shows a top side of the circuit board 14 in more detail. The circuit board 14 comprises a rigid mounting portion 22 and a flexible connecting portion 24 that is connected to the mounting portion 22.

The mounting portion 22 has an essentially rectangular shape, wherein the mounting portion 22 is complementary to the inner area of the depression 16 of the housing 12, or smaller than the inner area of the depression 16 of the housing 12.

However, it is to be understood that the mounting portion 22 may also have any suitable shape other than the essentially rectangular shape.

The mounting portion 22 comprises at least one electronic circuit 26 on its top side. For example, the electronic circuit 26 may comprise a printed electronic circuit that is printed on the top side of the mounting portion 22, and/or other electronic components, such as FPGAs, ASICs, etc.

In general, the electronic circuit 26 is configured to control at least one functionality of the electronic device 10. Particularly, the electronic circuit 26 is configured to switch between at least two different operational modes of the electronic device 10, such as "on" and "off", or between different channels of the handheld radio.

The mounting portion 22 further comprises several grounding portions 28 that are each electrically connected with a ground plane of the electronic circuit 26.

The grounding portions 28 are established as bendable lugs that extend outwardly from the mounting portion 22, particularly within one plane in the unfolded or rather non-bent state, which is shown in Figure 2.

The lugs may each consist out of a conductive metal, or may be covered with a conductive metal at least on their top side. Particularly, the lugs are each covered with a gold layer at least on their top side.

In general, the grounding portions 28 immediately abut the housing 12 in the mounted state of the electronic device 10, which is shown in Figure 1. Thus, the grounding portions 28 electrically connect the ground plane of the at least one electronic circuit 26 with the housing 12, thereby enhancing the electromagnetic screening of the circuit board 14.

On the opposite side, the mounting portion 22 comprises one or several metallic snap domes 30 that are arranged at least over portions of the electronic circuit 26, which are contacted by the cover portion connected with the threaded holes 20, thereby establishing the switch as mentioned above.

Between the electronic circuit 26 and each of the snap domes 30, a switching mat may be provided, respectively. When the snap domes 30 are actuated, an electric circuit is closed by means of the switching mat, and a switching operation may be triggered.

If the circuit board 14 is mounted to the housing 12, and the cover portion of the housing 12 is attached to the housing 12, the snap domes 30 may abut the cover portion of the housing 12, such that a mechanical and/or electrical connection is established, thereby ensuring a switching operation.

The mounting portion 22 further comprises two lateral recesses 31, which are arranged on opposite sides of the mounting portion 22.

The lateral recesses 31 are complementary to the lugs 18 of the housing 12, such that the circuit board 14 or rather the mounting portion 22 can be securely positioned in the depression 16 during assembly of the electronic device 10.

In other words, the lugs 18 and the recesses 31 cooperate in order to guide the circuit board 14 into the correct position, and to hold the circuit board 14 in the correct position during the assembly of the electronic device 10.

The flexible connecting portion 24 comprises a plug connector 32 and a flexible printed circuit board 34 for connecting the circuit board 14 with at least one further electronic component of the electronic device 10.

The plug connector 32 is arranged at an end of the connecting portion 24 that is facing away from the mounting portion 22.

The flexible printed circuit board 34 connects the plug connector 32 with the at least one electronic circuit 26 of the circuit board 14. As the connecting portion 24, particularly the printed circuit board 34, is configured to be flexible, manufacturing tolerances of the electronic device 10 and of the circuit board 14 can be compensated by means of the flexible connecting portion 24 in three dimensions.

Accordingly, a switching operation initiated via the cover portion of the housing is transmitted to the snap dome(s) 30, which interact with the switching mat(s) and the electronic components provided on the circuit board 14 such that signals are forwarded to the plug connector 32 for controlling the at least one further electronic component of the electronic device 10 that is connected with the plug connector 32.

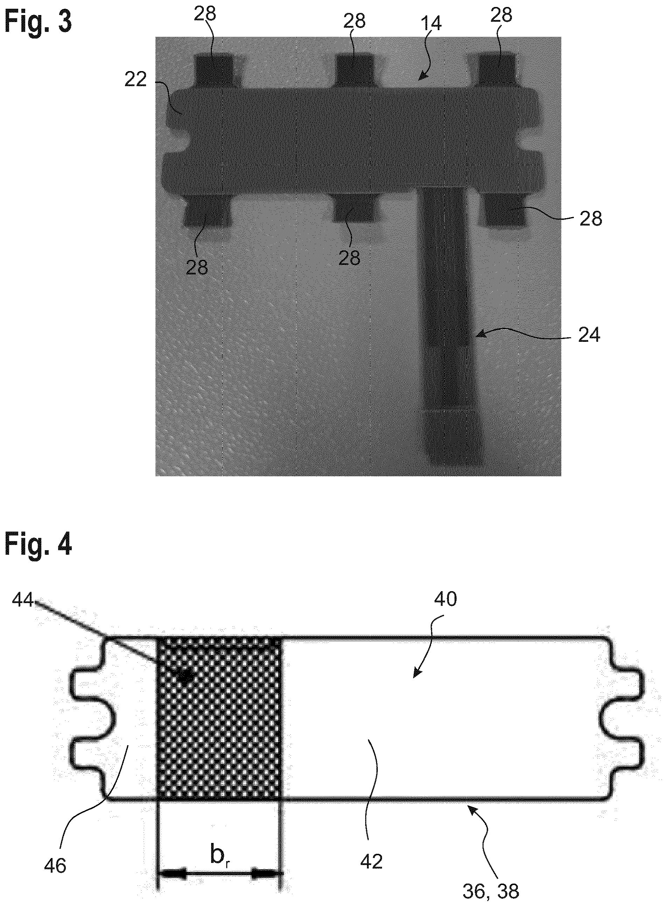

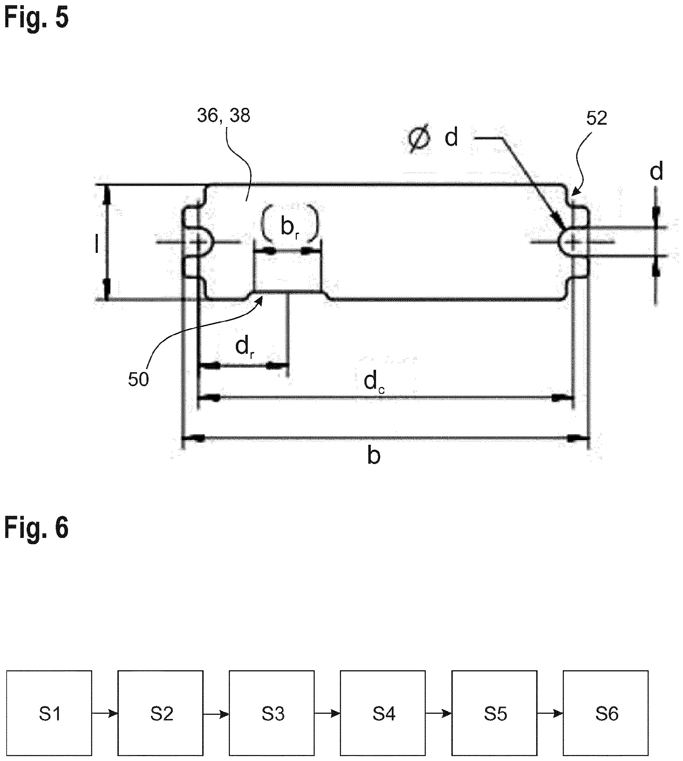

Figure 3 shows a bottom side of the circuit board 14. On its bottom side, the mounting portion 22 comprises at least one elastic mounting member 36 for mounting the circuit board 14 to the housing 12, wherein the mounting member 36 is not visible in Figure 3, but it is shown in Figures 4 and 5.

The at least one elastic mounting member 36 is established as a rubber foam pad 38 that respectively comprises an adhesive layer on its top side, which is facing the mounting portion 22, and on its bottom side, which faces away from the mounting portion 22.

Accordingly, the rubber foam pad 38 is glued to the mounting portion 22 by means of the adhesive layer that is arranged on the top side of the rubber foam pad 38.

Moreover, the mounting portion 22 can be glued into the depression 16 of the housing 12 by means of the adhesive layer that is arranged on the bottom side of the rubber foam pad 38.

Before mounting of the circuit board 14 to the housing 12, the elastic mounting member 36 comprises a removable cover strip 40 on its bottom side, wherein the cover strip 40 covers the adhesive layer on the bottom side of the rubber foam pad 38.

As is illustrated in Figure 4, the cover strip 40 comprises several cover strip portions 42, 44, 46, which are individually removable from the adhesive layer on the bottom side of the rubber foam pad 38, i.e. on the side that is facing away from the mounting portion 22.

It is noted that while the cover strip 40 comprises three covers strip portions 42, 44, 46 in the exemplary embodiment shown in Figure 4, the cover strip 40 may comprise any other number of cover strip portions other than three, for example one, two, or four cover strip portions.

In the exemplary embodiment shown in Figure 4, the cover strip portions 42, 44, 46 are arranged side by side along a width-dimension of the mounting portion 22.

The middle cover strip portion 44 may be arranged adjacent to the flexible connecting portion 24, while the other two cover strip portions 42, 46 are laterally offset to the middle cover strip portion 44.

Neighboring cover strip portions 42, 44, 46 may be separated from each other by means of a perforation in the cover strip 40 that facilitate individual removal of the cover strip portions 42, 44, 46.

Figure 5 shows a top side of the elastic mounting member 36, i.e. the side of the elastic mounting member 36 that is facing the mounting portion 22. Hence, the side shown in Figure 5 is opposite to the one shown in Figure 4.

The elastic mounting member 36 has an overall length I that is either equal to or smaller than the overall length of the mounting portion 22.

Moreover, the elastic mounting member 36 has an overall width b that is either equal to or smaller than the overall width of the mounting portion 22.

On its opposing lateral sides, the elastic mounting member 36 comprises two semicircular recesses 48 having a diameter d, which is either equal to or bigger than a diameter of the recesses 31 of the mounting portion 22.

The centers of the semicircular recesses 48 are spaced apart by a distance d_{c}, which is equal to the distance between the centers of the lateral recesses 31 of the mounting portion 22.

The elastic mounting member 36 comprises a further recess 50 at a lateral side that is facing the flexible connecting portion 24. The recess 50 has a width bᵣ that is equal to or bigger than the width of the flexible connecting portion 24.

A center of the recess 50 is spaced from the center of the nearer lateral recess 48 of the elastic mounting member by a distance dᵣ, such that axial symmetry lines of the recess 50 and of the flexible connecting portion 24 coincide.

Moreover, the elastic mounting member 36 may have cutaways 52 at its corners.

Accordingly, the elastic mounting member 36 covers a bottom surface of the mounting portion 22 only partially.

However, it is also conceivable that the elastic mounting member 36 covers the bottom surface of the mounting portion 22 completely.

Figure 6 shows a flow chart of a method of assembling the electronic device 10 described above.

The housing 12 and the circuit board 14 described above are provided (step S1).

At least on of the cover strip portions 42, 44, 46 is removed (step S2). In general, only the cover strip portions 42, 44, 46 that need to be removed for the particular mounting configuration of the electronic device 10 are actually removed. For example, if the flexible connecting portion 24 is to be (partially) glued to the bottom side of the mounting portion 22, then all cover strip portions 42, 44, 46 may be removed.

If, however, the flexible connecting portion shall not be glued to the bottom side of the mounting portion 22, then only the lateral cover strip portions 42, 46 may be removed, while the center cover strip portion 44 may remain on the rubber foam pad 38.

Accordingly, the flexible connecting portion 24 may be glued to the bottom side of the mounting portion 22, and thus may be partially fixed to the circuit board 14.

The grounding portions 28 are bent towards the bottom side of the mounting portion 22 (step S3).

If necessary, the grounding portions 28 may be glued to the bottom side of the rubber foam pad 38 by means of the adhesive layer on the rubber foam pad 38. In this case, the grounding portions 28 are bent until they contact the adhesive layer on the bottom side of the rubber foam pad 38.

The flexible connecting portion 24, or more precisely the plug connector 32, is connected to at least one further electronic component of the electronic device 10 (step S4).

It is noted that step S4 may, in principle, also be performed before step S2 and/or before step S3.

The mounting portion 22 is glued into the depression 16 by means of the adhesive layer of the rubber foam pad 38, such that the grounding portions 28 immediately abut the housing 12 (step S5).

Therein, the lateral recesses 31 in the mounting portion 22 and the lateral lugs 18 of the housing cooperate to guide the mounting portion 22 into the correct position.

Finally, a cover portion of the housing 12 may be screwed onto the housing 12 via the threaded holes 20, such that the housing 12 is closed (step S6), thereby contacting the snap dome(s) 30 for establishing the switch.

Summarizing, the circuit board 14 described above can be mounted to the housing 12 of the electronic device 10 by means of the elastic mounting member 36 in a particularly simple fashion. More precisely, the circuit board 14 or rather the mounting portion 22 is glued to the housing via the adhesive layer of the rubber foam pad 38.

As the rubber foam pad 38 is elastic, manufacturing tolerances of the circuit board 14 and/or of the housing 12 of the electronic device 10 are compensated at least partially by the elastic mounting member 36.

Moreover, the flexible connecting portion 24 ensures that the circuit board 14 can be connected to other electronic components of the electronic device 10 in an easy manner, as the flexible connecting portion 24 can simply be bent such that it contacts the corresponding electronic component.

The flexible connecting portion 24 also compensates for manufacturing tolerances of the circuit board 14 and/or for manufacturing tolerances of the housing 12 to which the circuit board 14 is mounted.

Additionally, the bendable grounding portions 28 also compensate for manufacturing tolerances, as the grounding portions 28 can be flexibly bent into the correct position such that they contact the housing 12.

## Claims

1. A circuit board for a handheld radio, comprising a rigid mounting portion (22), a flexible connecting portion (24) for electronically connecting the circuit board (14) to other electronic components, at least one grounding portion (28) for grounding the circuit board (14), and at least one electronic circuit (26), and
wherein the at least one electronic circuit (26) is provided on a top side of the mounting portion (22),
**characterized in that** the mounting portion (22) comprises an elastic mounting member (36) on a bottom side of the mounting portion (22), which is opposite to the top side, wherein the circuit board (14) is mountable directly to a housing (12) of an electronic device (10) by means of the elastic mounting member (36).

2. The circuit board of claim 1, **characterized in that** the elastic mounting member (36) comprises an adhesive film.

3. The circuit board of claim 2, **characterized in that** the adhesive film is covered with a removable cover strip (40).

4. The circuit board of claim 3, **characterized in that** the removable cover strip (40) comprises several cover strip portions (42, 44, 46), wherein the several cover strip portions (42, 44, 46) are removable individually.

5. The circuit board according to any one of the preceding claims, **characterized in that** the elastic mounting member (36) comprises a rubber foam pad (38).

6. The circuit board according to any one of the preceding claims, **characterized in that** the at least one grounding portion (28) is established as a lug being immediately connected to the circuit board (14).

7. The circuit board according to any one of the preceding claims, **characterized in that** the at least one grounding portion (28) is bendable with respect to the mounting portion (22).

8. The circuit board according to any of the preceding claims, **characterized in that** the at least one grounding portion (28) comprises a conductive metal, particularly gold.

9. The circuit board according to any of the preceding claims, **characterized in that** the mounting portion (22) has an essentially rectangular shape.

10. The circuit board according to any one of the preceding claims, **characterized in that** the mounting portion (22) comprises at least one lateral recess (31) or lug.

11. The circuit board according to any one of the preceding claims, **characterized in that** the flexible connecting portion (24) comprises a printed circuit board (34).

12. The circuit board according to any one of the preceding claims, **characterized in that** the connecting portion (24) comprises a plug connector (32), particularly wherein the plug connector (32) is arranged at an end of the connecting portion (24) being opposite to the mounting portion (22).

13. A control unit, particularly for a handheld radio, comprising a circuit board (14) according to any one of the preceding claims, wherein the control unit is established as a switch.

14. An electronic device, particularly a handheld radio, comprising a housing (12), a circuit board (14) according to any one of the claims 1 to 12, and/or a control unit according to claim 13, wherein the grounding portion (28) of the circuit board (14) immediately abuts the housing (12).

15. A method of assembling an electronic device (10), wherein the method comprises the steps of:
- Providing a circuit board (14) according to any of claims 1 to 12,
- Bending the at least one grounding portion (28) with respect to the mounting portion (22),
- Inserting the circuit board (14) into a housing (12) of the electronic device (10) such that the at least one bent grounding portion (28) immediately abuts the housing (12).

## Patentansprüche

1. Leiterplatte für ein Handfunkgerät, umfassend einen starren Montageabschnitt (22), einen flexiblen Verbindungsabschnitt (24) zum elektronischen Verbinden der Leiterplatte (14) mit anderen elektronischen Komponenten, mindestens einen Erdungsabschnitt (28) zum Erden der Leiterplatte (14) und mindestens eine elektronische Schaltung (26), und
wobei die mindestens eine elektronische Schaltung (26) auf einer Oberseite des Montageabschnitts (22) bereitgestellt ist,
**dadurch gekennzeichnet, dass** der Montageabschnitt (22) ein elastisches Montageelement (36) auf einer Unterseite des Montageabschnitts (22) umfasst, die der Oberseite gegenüberliegt, wobei die Leiterplatte (14) mittels des elastischen Montageelements (36) an ein Gehäuse (12) einer elektronischen Vorrichtung (10) direkt montierbar ist.

2. Leiterplatte nach Anspruch 1, **dadurch gekennzeichnet, dass** das elastische Montageelement (36) eine Klebefolie umfasst.

3. Leiterplatte nach Anspruch 2, **dadurch gekennzeichnet, dass** die Klebefolie mit einem entfernbaren Abdeckstreifen (40) abgedeckt ist.

4. Leiterplatte nach Anspruch 3, **dadurch gekennzeichnet, dass** der entfernbare Abdeckstreifen (40) mehrere Abdeckstreifenabschnitte (42, 44, 46) umfasst, wobei die mehreren Abdeckstreifenabschnitte (42, 44, 46) einzeln entfernbar sind.

5. Leiterplatte nach einem der vorstehenden Ansprüche,
**dadurch gekennzeichnet, dass** das elastische Montageelement (36) ein Schaumgummipolster (38) umfasst.

6. Leiterplatte nach einem der vorstehenden Ansprüche,
**dadurch gekennzeichnet, dass** der mindestens eine Erdungsabschnitt (28) als Nase ausgebildet ist, die mit der Leiterplatte (14) unmittelbar verbunden ist.

7. Die Leiterplatte nach einem der vorstehenden Ansprüche,
**dadurch gekennzeichnet, dass** der mindestens eine Erdungsabschnitt (28) hinsichtlich des Montageabschnitts (22) biegbar ist.

8. Leiterplatte nach einem der vorstehenden Ansprüche,
**dadurch gekennzeichnet, dass** der mindestens eine Erdungsabschnitt (28) ein leitfähiges Metall, insbesondere Gold, umfasst.

9. Leiterplatte nach einem der vorstehenden Ansprüche,
**dadurch gekennzeichnet, dass** der Montageabschnitt (22) eine im Wesentlichen rechteckige Form aufweist.

10. Leiterplatte nach einem der vorstehenden Ansprüche,
**dadurch gekennzeichnet, dass** der Montageabschnitt (22) mindestens eine seitliche Aussparung (31) oder Nase umfasst.

11. Leiterplatte nach einem der vorstehenden Ansprüche,
**dadurch gekennzeichnet, dass** der flexible Verbindungsabschnitt (24) eine gedruckte Leiterplatte (34) umfasst.

12. Leiterplatte nach einem der vorstehenden Ansprüche,
**dadurch gekennzeichnet, dass** der Verbindungsabschnitt (24) einen Steckverbinder (32) umfasst, insbesondere wobei der Steckverbinder (32) an einem Ende des Verbindungsabschnitts (24) arrangiert ist, das dem Montageabschnitt (22) gegenüberliegt.

13. Steuereinheit, insbesondere für ein Handfunkgerät, umfassend eine Leiterplatte (14) nach einem der vorstehenden Ansprüche, wobei die Steuereinheit als ein Schalter ausgebildet ist.

14. Elektronische Vorrichtung, insbesondere ein Handfunkgerät, umfassend ein Gehäuse (12), eine Leiterplatte (14) nach einem der Ansprüche 1 bis 12 und/oder eine Steuereinheit nach Anspruch 13, wobei der Erdungsabschnitt (28) der Leiterplatte (14) an das Gehäuse (12) unmittelbar anstößt.

15. Verfahren zum Zusammenbauen einer elektronischen Vorrichtung (10), wobei das Verfahren die Schritte umfasst:
- Bereitstellen einer Leiterplatte (14) nach einem der Ansprüche 1 bis 12,
- Biegen des mindestens einen Erdungsabschnitts (28) hinsichtlich des Montageabschnitts (22),
- Einsetzen der Leiterplatte (14) in ein Gehäuse (12) der elektronischen Vorrichtung (10), derart, dass der mindestens eine gebogene Erdungsabschnitt (28) an das Gehäuse (12) unmittelbar anstößt.

## Revendications

1. Carte de circuit imprimé pour une radio portative, comprenant une partie de montage rigide (22), une partie de connexion flexible (24) pour connecter électroniquement la carte de circuit imprimé (14) à d'autres composants électroniques, au moins une partie de mise à la terre (28) pour mettre à la terre la carte de circuit imprimé (14), et au moins un circuit électronique (26), et
dans laquelle l'au moins un circuit électronique (26) est fourni sur une face supérieure de la partie de montage (22),
**caractérisée en ce que** la partie de montage (22) comprend un élément de montage élastique (36) sur une face inférieure de la partie de montage (22), qui est opposée à la face supérieure, dans laquelle la carte de circuit imprimé (14) peut être montée directement sur un boîtier (12) d'un dispositif électronique (10) au moyen de l'élément de montage élastique (36).

2. Carte de circuit imprimé selon la revendication 1, **caractérisée en ce que** l'élément de montage élastique (36) comprend un film adhésif.

3. Carte de circuit imprimé selon la revendication 2, **caractérisée en ce que** le film adhésif est recouvert d'une bande de recouvrement amovible (40).

4. Carte de circuit imprimé selon la revendication 3, **caractérisée en ce que** la bande de recouvrement amovible (40) comprend plusieurs parties de bande de recouvrement (42, 44, 46), dans laquelle les plusieurs parties de bande de recouvrement (42, 44, 46) sont amovibles individuellement.

5. Carte de circuit imprimé selon l'une quelconque des revendications précédentes, **caractérisée en ce que** l'élément de montage élastique (36) comprend un tampon en mousse de caoutchouc (38).

6. Carte de circuit imprimé selon l'une quelconque des revendications précédentes, **caractérisée en ce que** l'au moins une partie de mise à la terre (28) est établie comme une cosse immédiatement connectée à la carte de circuit imprimé (14).

7. Carte de circuit imprimé selon l'une quelconque des revendications précédentes, **caractérisée en ce que** l'au moins une partie de mise à la terre (28) peut être courbée par rapport à la partie de montage (22).

8. Carte de circuit imprimé selon l'une quelconque des revendications précédentes, **caractérisée en ce que** l'au moins une partie de mise à la terre (28) comprend un métal conducteur, en particulier de l'or.

9. Carte de circuit imprimé selon l'une quelconque des revendications précédentes, **caractérisée en ce que** la partie de montage (22) a une forme essentiellement rectangulaire.

10. Carte de circuit imprimé selon l'une quelconque des revendications précédentes, **caractérisée en ce que** la partie de montage (22) comprend au moins un renfoncement latéral (31) ou une cosse.

11. Carte de circuit imprimé selon l'une quelconque des revendications précédentes, **caractérisée en ce que** la partie de connexion flexible (24) comprend une carte de circuit imprimé (34).

12. Carte de circuit imprimé selon l'une quelconque des revendications précédentes, **caractérisée en ce que** la partie de connexion (24) comprend un connecteur de fiche (32), en particulier dans laquelle le connecteur de fiche (32) est disposé à une extrémité de la partie de connexion (24) étant opposée à la partie de montage (22).

13. Unité de commande, en particulier pour une radio portative, comprenant une carte de circuit imprimé (14) selon l'une quelconque des revendications précédentes, dans laquelle l'unité de commande est établie en tant que commutateur.

14. Dispositif électronique, en particulier une radio portative, comprenant un boîtier (12), une carte de circuit imprimé (14) selon l'une quelconque des revendications 1 à 12, et/ou une unité de commande selon la revendication 13, dans lequel la partie de mise à la terre (28) de la carte de circuit imprimé (14) est en contact direct avec le boîtier (12).

15. Procédé d'assemblage d'un dispositif électronique (10), dans lequel le procédé comprend les étapes consistant à :
- fournir une carte de circuit imprimé (14) selon l'une quelconque des revendications 1 à 12,
- courber l'au moins une partie de mise à la terre (28) par rapport à la partie de montage (22),
- insérer la carte de circuit imprimé (14) dans un boîtier (12) du dispositif électronique (10) de telle sorte que l'au moins une partie de mise à la terre courbée (28) est en contact direct avec le boîtier (12).
